# EUROPÄISCHE PATENTSCHRIFT

(11) **EP 0 796 452 B1**
(45) Veröffentlichungstag und Bekanntmachung des Hinweises auf die Patenterteilung: **26.03.2003**
(21) Anmeldenummer: 96933349.1
(22) Anmeldetag: 20.09.1996
(51) Int. Cl.: G02B 27/14, H01S 3/23, G02B 27/09

(54) **ANORDNUNG ZUR ZUSAMMENFÜHRUNG UND FORMUNG DER STRAHLUNG MEHRERER LASERDIODENZEILEN**
DEVICE FOR COMBINING AND SHAPING THE RADIATION FROM SEVERAL LASER DIODE CELLS
DISPOSITIF DE COMBINAISON ET DE MISE EN FORME D'UN RAYONNEMENT EMANANT DE PLUSIEURS DIODES LASER

(30) Priorität: 06.10.1995 DE 19537265
(43) Veröffentlichungstag der Anmeldung: 24.09.1997
(73) Patentinhaber: JENOPTIK Aktiengesellschaft, 07739 Jena (DE)
(72) Erfinder: HOLLEMANN, Günter, D-07749 Jena (DE); VOELCKEL, Hermann, D-07768 Kahla (DE); CHALEEV, Michail Michailovic, St. Petersburg, 195296 (RU); MAK, Arthur Afanasevic, St. Petersburg, 199226 (RU); USTYUGOV, Vladimir Ivanovic, St. Petersburg, 195257 (RU); MICHAILOV, Aleksej Vadimovic, St. Petersburg, 197042 (RU); NOVIKOV, Georgij Egorovic, St. Petersburg, 199007 (RU); ORLOV, Oleg Aleksandrovic, St. Petersburg, 190008 (RU)
(74) Vertreter: Oehmke, Volker, Dipl.-Math.
(86) Internationale Anmeldenummer: EP9604127
(87) Internationale Veröffentlichungsnummer: WO97014073

(56) Entgegenhaltungen:
- US-A- 4 978 197
- US-A- 5 333 077
- OPTICS LETTERS, Bd. 20, Nr. 2, 15.Januar 1995, Seiten 222-224, XP000486652 EDWIN R P: "STRIPE STACKER FOR USE WITH LASER DIODE BARS"
- OPTICS LETTERS, Bd. 20, Nr. 8, 15.April 1995, Seiten 898-900, XP000499612 YAMAGUCHI S ET AL: "COLLIMATION OF EMISSIONS FROM A HIGH-POWER MULTISTRIPE LASER-DIODE BAR WITH MULTIPRISM ARRAY COUPLING AND FOCUSING TO A SMALL SPOT"
- CONFERENCE ON LASERS AND ELECTRO-OPTICS (CLEO) 1994 8-13 MAY 1994 ANAHEIM CA, Seite 360 XP002022307 W.A. CLARCKSON ET AL: "Novel beam shaping technique for high power diode bars"

## Beschreibung

Die Erfindung betrifft eine Anordnung, mit welcher die Strahlung mehrerer Laserdiodenzeilen zusammengeführt und geformt wird, um sie beispielsweise in eine optische Faser oder die Stirnfläche eines Festkörperlaserstabes einzukoppeln.

Sie stellt eine Laserdiodenzeilenlichtquelle dar, die beispielsweise in der Laserchirurgie, der Lasermaterialbearbeitung oder zum Pumpen von Festkörperlasern vorteilhaft einsetzbar ist.

Laserdioden zeichnen sich gegenüber anderen Lasern besonders durch ihren hohen Wirkungsgrad aus, der jedoch mit sehr hohen Stromdichten verbunden ist, welche nur sehr kleine Abmessungen und damit begrenzte Ausgangsleistungen erlauben.
Es macht sich daher in vielen Anwendungsfällen, in denen eine höhere Laserleistung benötigt wird, erforderlich, die Strahlungsleistung mehrerer Laserdioden zu nutzen und diese entsprechend zusammen zu führen.
Insbesondere, wenn das vereinigte Strahlenbündel in ein nachfolgendes Gerät oder optisches Element eingekoppelt werden soll, ist eine hohe Strahlqualität, bestimmt durch die Abmessung des Strahlquerschnitts und die Fernfelddivergenz der Strahlung, erforderlich.
Bei Laserdioden ergibt sich aufgrund des Querschnitts der Emissionsfläche von ca.1µm x 100 µm ein asymmetrischer Querschnitt für das jeweils emittierende Strahlenbündel mit einer Längsachse der ca. hundertfachen Länge der Querachse. Diese Asymmetrie vervielfacht sich bei der Strahlung einer Laserdiodenzeile durch die technologisch und kühltechnisch erforderliche Anordnung der einzelnen Emissionsflächen, die auf einer Geraden entlang ihrer Längsachsen angeordnet sind. Zu dieser sich daraus ergebenden ungünstigen Strahlgeometrie kommt die in der Längs- und Querachse stark unterschiedliche Divergenz der Strahlung. Bekanntlich ist die Divergenz der Laserdiodenstrahlung in Richtung der Querachse, senkrecht zur Ebene des p-n-Übergangs der Laserdiode, bis zu 90°, während sie in Richtung der Längsachse, also parallel zur Ebene des p-n-Übergangs, nur etwa 10° beträgt. Aus der stark asymmetrischen Strahlgeometrie und der Divergenz des Strahlenbündels einer Laserdiodenzeile ergeben sich hohe Anforderungen an eine Anordnung zur Zusammenführung und Formung der Strahlung, die letztendlich ein an die Apertur der Nachfolgeoptik angepaßtes Strahlenbündel erzeugen muß, um eine hohe Einkoppeleffizienz zu erreichen.

Anordnungen zum Bundeln der Strahlung von Laserdioden sind beispielsweise beschrieben in US-A-4 978 197 oder in Optics Letters, Bd 20, Nr. 2 vom 15.01.95, S222-224, Edwin R.P.: "Stripe Stacker for use with Laser Diode Bars".

Die Aufgabe der Erfindung besteht in der Schaffung einer neuen Anordnung, mit welcher die Strahlung mehrerer Laserdiodenzeilen so zusammengeführt und geformt wird, daß das gemeinsame Strahlenbündel einen möglichst kleinen Querschnitt mit möglichst geringer Asymmetrie und Femfelddivergenz aufweist.

Diese Aufgabe wird mit einer Anordnung gemäß Patentanspruch 1 gelöst. Vorteilhafte Ausgestaltungen sind in den Unteransprüchen beschrieben.

Die Erfindung beruht im Wesentlichen auf der Auswahl und Reihenfolge der Anordnung optisch wirksamer Mittel zur Formung, Umlenkung. Trennung und Zusammenführung der Strahlung mehrerer Laserdiodenzeilen zu einem Strahlenbündel. Dabei ist entscheidend, daß folgende Mittel in folgender Reihenfolge in Strahlungsrichtung den Laserdiodenzeilen nachgeordnet sind:
1. Mittel zum Kollimieren der Strahlung der Laserdiodenzeilen (Kollimiereinheit)
2. Mittel zum Zusammenführen der kollimierten Strahlungen durch Nebeneinanderordnen in Richtung der Querachse der Strahlungen (Kombiniereinheit)
3. Mittel zum Teilen der zusammengeführten Strahlung in Richtung der Längsachse der Strahlung und Mittel zur Umlenkung der Teilstrahlenbündel, um diese in Richtung der Querachse nebeneinander wiedervereint anzuordnen (Rekombiniereinheit)

Wie an Hand der Ausführungsbeispiele an späterer Stelle genauer erläutert wird, kann die Rekombiniereinheit beispielsweise durch ein integriert-optisches Element oder eine Anordnung optischer Einzelelemente, die einen bzw. mehrere Module bilden, verkörpert werden. Die Strahlteilung innerhalb eines integriert-optischen Elementes oder eines Moduls kann durch Reflexion an in Strahlungsrichtung zueinander versetzten Planflächen gleicher Winkellage (1. Ausführungsbeispiel) oder durch Reflexion an Planflächen unterschiedlicher Winkellage zur Strahlungsrichtung (2. Ausführungsbeispiel) erfolgen. Die Umlenkung und Wiedervereinigung der Strahlung erfolgt durch je eine 90°-Reflexion der Teilstrahlenbündel in zwei zueinander senkrechten Ebenen, wodurch die Teilstrahlenbündel gedreht und wieder zusammengeführt nebeneinander angeordnet werden.
Soll das erzeugte Strahlenbündel z.B. in ein nachfolgendes optisches Element eingekoppelt werden, wird die Anordnung durch eine Sammeloptik als Mittel zum Einkoppeln ergänzt.

Die Erfindung wird im folgenden anhand der Zeichnung an zwei Ausführungsbeispielen näher erläutert. Darin zeigen:
- Fig.1:: eine schematische Darstellung eines ersten Ausführungsbeispiels der Erfindung mit einem integriert-optischen Element - 3.1 als Rekombiniereinheit 3
- Fig.2a-d:: das integriert-optische Element des in Fig. 1 dargestellten Ausführungsbeispiels in Dreiseitenansicht und perspektivischer Darstellung
- Fig.3:: eine schematische Darstellung eines zweiten Ausführungsbeispiels mit drei Modulen 3.2 als Rekombiniereinheit 3

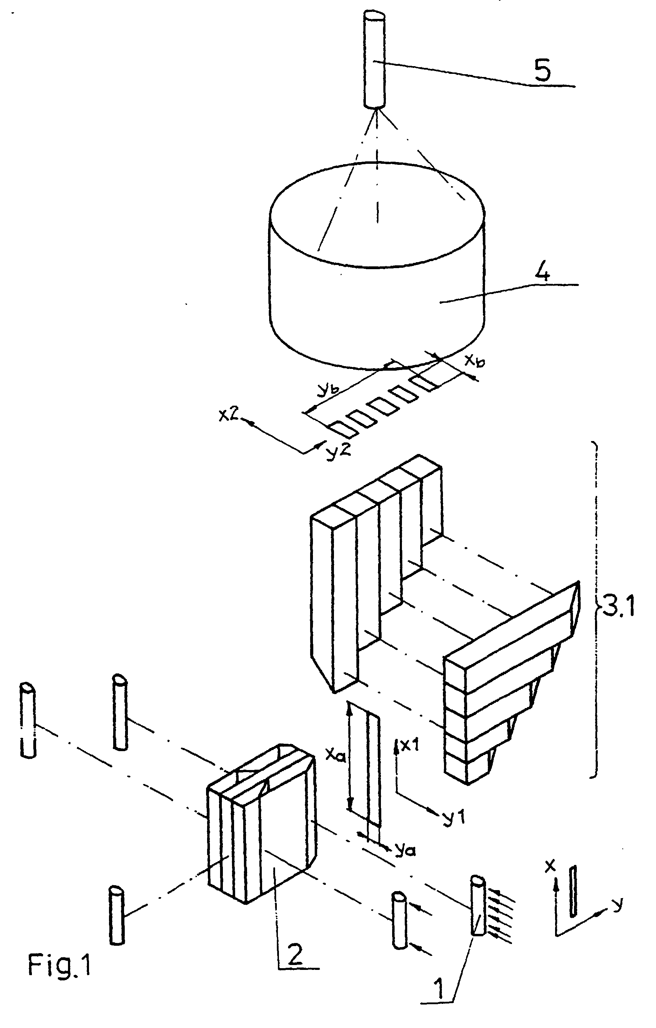

Das in Fig. 1 dargestellte Ausführungsbeispiel einer erfindungsgemäßen Anordnung zur Zusammenführung und Formung der Strahlung mehrerer Laserdiodenzeilen umfaßt fünf der Übersichtlichkeit halber nicht dargestellte Laserdiodenzeilen, fünf Kollimationseinheiten 1, eine Kombiniereinheit 2, ein integriert-optisches Element 3.1 als Rekombiniereinheit 3 und eine Sammeloptik 4. Zum besseren Verständnis der Veränderung der Strahlgeometrie wird ein karthesisches x-y-Koordinatensystem eingeführt und an verschiedenen Orten im optischen Strahlengang transformiert dargestellt. Seine zwei Koordinaten werden durch die Lage einer der Laserdiodenzeilen definiert.
Bei den Laserdiodenzeilen handelt es sich, wie eingangs der Beschreibung erwähnt, um solche, bei denen die Emissionsflächen in einer Ebene mit ihren Längsachsen auf einer Geraden angeordnet sind. Die Ausrichtung der Längsachsen definiert die x-Achse und die Ausrichtung der Querachsen die y-Achse des Koordinatensystems. In der x-y-Ebene, gleich der Ebene der Emissionsflächen der Laserdiodenzeile, ist die Strahlgeometrie durch die Anordnung der Emissionsflächen bestimmt und stellt demnach einen Streifen z.B mit dem Abmaß von ca. 1µm x 10 mm dar. In der Zeichnung kann diese Proportion wie auch die Größenverhältnisse der Strahlquerschnitte in den einzelnen Transformationsebenen des Koodinatensystems nicht gewahrt werden.
Jeder der fünf Laserdiodenzeilen ist in Strahlungsrichtung eine Kollimationseinheit 1 unmittelbar nachgeordnet. Die Kollimationseinheiten 1 werden durch je eine Einzelzylinderlinse 6 gebildet, welche die Strahlung in y-Richtung kollimiert. Zur Erlangung einer noch höherer Strahlqualität kann die Kollimationseinheit zusätzlich eine Zylinderlinsenzeile umfassen, welche die Strahlung in x-Richtung kollimiert. Vorteilhafterweise können die Einzelzylinderlinse 6 als auch die Linsen der Zylinderlinsenzeile, sofern vorhanden, ein asphärisches Profil aufweisen, um sphärische Aberrationen zu eliminieren.
Die Kollimationseinheit 1 kann selbstverständlich auch durch andere optische Elemente gebildet werden, die eine Kollimation der Strahlung in y-Richtung oder auch in x- und y-Richtung bewirken, wie beispielsweise Gradientenindexlinsen.

Allen Kollimationseinrichtungen 1 ist gemeinsam in Strahlungsrichtung die Kombiniereinheit 2 nachgeordnet, welche die kollimierte Strahlung der einzelnen Laserdiodenzeilen zusammenführt. Diese Kombiniereinheit 2 besteht aus einer bestimmten Anzahl von transparenten Platten mit reflektierenden Facetten, deren Anzahl und Anordnung durch die Anzahl und Anordnung der Laserdiodenzeilen bestimmt ist. Im Ausführungsbeispiel, bei dem von fünf Laserdiodenzeilen vier in zueinander parallelen Ebenen angeordnet sind und paarweise im entgegengesetzten Richtungssinn die Strahlung emittieren, während die fünfte Laserdiodenzeile in einer dazu senkrechten Richtung steht, umfaßt die Kombiniereinheit 2, hier als integriert-optisches Element konstruiert, drei Platten. Während die mittlere Platte die kollimierte Strahlung einer Laserdiodenzeile unbeeinflußt passieren läßt, wird die kollimierte Strahlung der anderen Laserdiodenzeilen an in den beiden äußeren Platten befindlichen Reflexionsflächen um 90° umgelenkt. Die Kombiniereinheit 2 kann selbstverständlich auch aus einzelnen optischen Elementen mit entsprechend angeordneten Reflexionsflächen bestehen. Das über die Kombiniereinheit 2 gebildete Strahlenbündel weist, im transformierten x₁-y₁-Koordinatensystem durch die Nebenordnung in Querrichtung bereits eine geringfügig günstigere Strahlgeometrie auf, als die Strahlung in der Ebene des x-y-Koordinatensystems. Während die Ausdehnung des Strahlungsbündelquerschnittes in x-Richtung konstant geblieben ist, ist die Ausdehnung in y-Richtung geringfügig vergrößert, so daß die Asymmetrie des gemeinsamen Strahlenbündels aller Laserdiodenzeilen geringer ist, als die der Strahlung einer einzelnen Laserdiodenzeile. Diese Verbesserung wirkt sich letztendlich in einer höheren, homogener verteilten Strahlungsenergie über den Strahlungsquerschnitt beim Einkoppeln in eine Nachfolgeoptik aus.

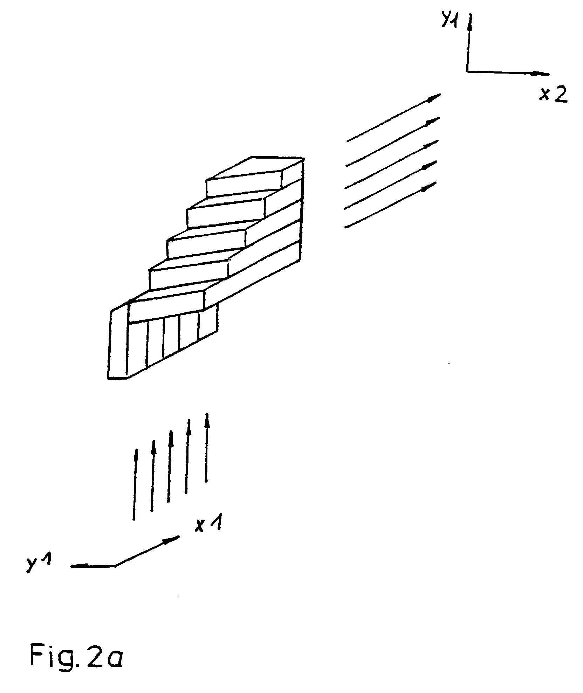

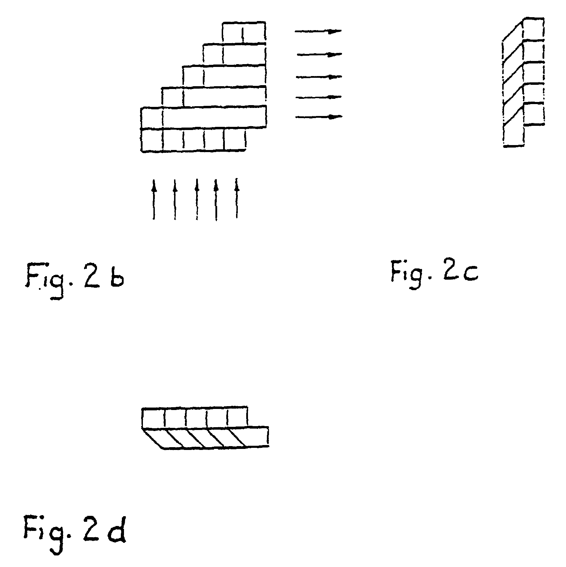

Die entscheidende Verbesserung der Geometrie des Strahlenbündels wird durch das der Kombiniereinheit 2 nachgeordnete integriert-optische Element 3.1 erzielt. Dieses bewirkt eine Strahlungsgeometrie, wie sie im transformierten x₂-y₂-Koordinatensystem dargestellt ist.
Das integriert-optische Element 3.1 besteht aus einer geradzahligen Anzahl von Rechteckstäben mit je einer 45°-Facette. Die Rechteckstäbe sind so dimensioniert und in Form zweier miteinander verbundener Stapel angeordnet, daß die Strahleintrittsflächen des in Strahlungsrichtung ersten Stapels, sowie die Strahlaustrittsflächen des in Strahlungsrichtung zweiten Stapels jeweils auf einer Geraden in zwei zueinander senkrechten Ebenen liegen. Innerhalb eines Stapels weisen die Rechteckstäbe eine linear abnehmende Länge auf. Die beiden Stapel sind so zueinander angeordnet, daß jeweils zwei Rechteckstäbe ein Stäbepaar mit je gleichem optischen Weg bilden und für je ein Teilstrahlenbündel als Wellenleiter wirken. Das integriert optische Element 3.1 kann auch aus einem Teil, mit den gleichen optischen Funktionsflächen wie beschrieben, gefertigt sein.
Ein integriert-optisches Element 3.1 mit fünf Stäben je Stapel, wie in Fig. 1 und genauer in Fig. 2a-d dargestellt, teilt entsprechend das auftreffende Strahlenbündel mit den Längenmaßen xₐ und yₐ, wie im x₁-y₁-Koordinatensystem bezeichnet, in fünf Teilbündel auf und lenkt diese über je eine zweifache Reflexion an den 45°-Facetten um, so daß diese nach Austritt aus dem integriert-optischen Element 3.1 ein Strahlenbündel mit den Längenmaßen x_{b} =xₐ/5 und y_{b} bilden, wobei y_{b} durch die Längendifferenz zwischen den jeweils äußeren Rechteckstäben eines Stapels bestimmt ist. Durch Optimierung der Anzahl der Rechteckstäbe und deren Längendifferenz kann die Differenz der Achslängen des Strahlenbündels in x₂- und y₂-Richtung nicht nur minimiert, sondern vollständig beseitigt werden, so daß ein zur optischen Achse nahezu symmetrisches Strahlenbündel entsteht.

Vorteilhafterweise ist dem integriert-optischen Element 3.1 eine Sammeloptik 4 nachgeordnet, welche das Strahlenbündel in eine nachfolgende Lichtleitfaser 5 einkoppelt.

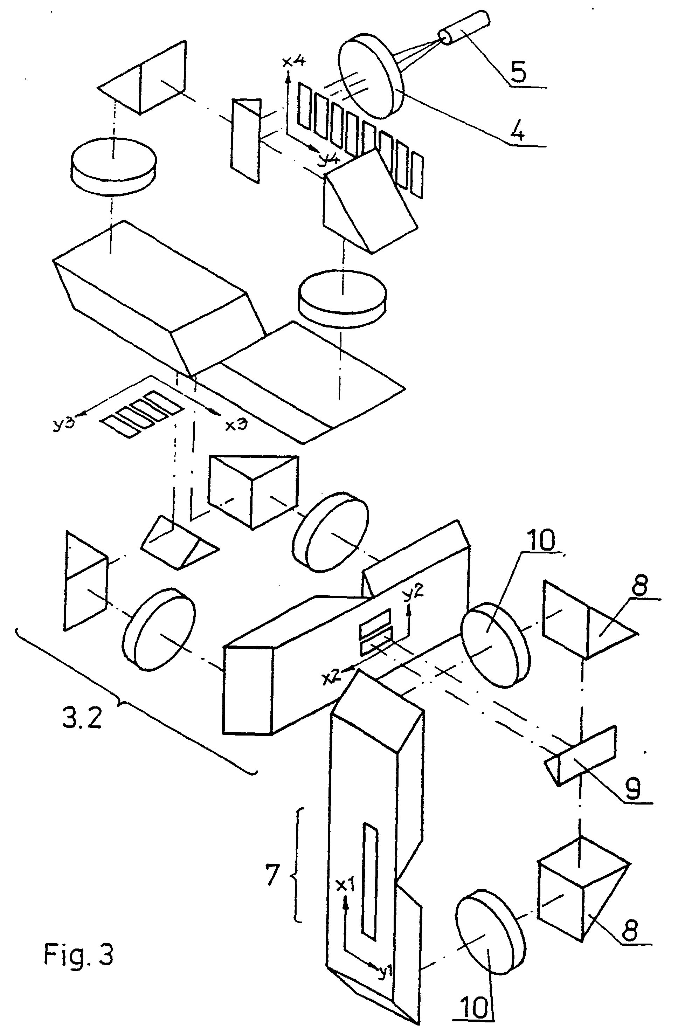

Das in Fig. 3 dargestellte zweite Ausführungsbeispiel unterscheidet sich zum beschriebenen ersten Ausführungsbeispiel lediglich in der Ausführung der Rekombiniereinheit 3, die hier aus drei Modulen 3.1 gebildet wird. Während die Strahlung durch ein integriert-optisches Element 3.1 mit N Rechteckstäbepaaren, wie im ersten Ausführungsbeispiel beschrieben, in N Teilstrahlenbündel zerlegt wird, erfolgt eine Zerlegung der Strahlung durch einen Modul 3.2 gemäß dem zweiten Ausführungsbeispiel in zwei Teilstrahlenbündel und Verwendung von M Modulen entsprechend in 2^{M} Teilstrahlenbündel.
Da die dem ersten der Module 3.2 vorgeordneten Laserdiodenzeilen, Kollimatoreinheiten 2 sowie die Kombiniereinheit 3 in Anzahl, Anordnung und Aufbau mit denen des ersten Ausführungsbeispiels identisch sind, sind diese in Fig. nicht noch einmal dargestellt.
Die einzelnen Module 3.2 sind identisch aufgebaut und zerlegen und lenken die jeweils auftreffende Strahlung in gleicher Weise. Sie bestehen jeweils aus einem Rhomboidprismenpaar 7, welches die auftreftende Strahlung in zwei Teilstrahlenbündel trennt, zwei Halbwürfelprismen 8 und einem Prisma 9, welche die Teilstrahlenbündel umlenken und wieder zusammenführen. Wie aus den dargestellten transformierten Koordinatensystemen ersichtlich, wird die Ausdehnung der Strahlung in x- Richtung mit jedem Modul halbiert, während die Ausdehnung in y-Richtung vergleichsweise geringfügig, bestimmt durch die Relativlage des Prismas 9 zu den Halbwürfelprismen 8, vergrößert wird. Ein gegenüber dem ersten Ausführungsbeispiel zusätzlicher Effekt wird hier durch die Anordnung einer Linse 10, jeweils vor die Halbwürfelprismen 8 erreicht. Die Linsen 10 ist dabei so angeordnet und dimensioniert, daß die Brennebenen der im optischen Strahlengang hintereinander angeordneten Linsen 10 zusammenfallen und damit Linsenwellenleiter bilden. Dies bietet gegenüber dem ersten Ausführungsbeispiel den zusätzlichen Vorteil, daß die von einer Brennebene zur nächsten übertragenen Lichtfelder durch eine räumliche Fourier-Transformation verbunden sind und damit auch eine winkelgerechte Vereinigung der Gesamtstrahlung erfolgt. verwendete Bezugszeichen
- 1: Kollimatoreinheit
- 2: Kombiniereinheit
- 3: Rekombiniereinheit
3.1 integriert-optisches Element
3.2 Modul
- 4: Sammeloptik
- 5: Lichtleitfaser
- 6: Einzelzylinderlinse
- 7: Rhomboidprismenpaar
- 8: Halbwürfelprisma
- 9: Prisma
- 10: Linse

## Patentansprüche

1. Anordnung zur Zusammenführung und Formung der Strahlung mehrerer Laserdiodenzeilen
bestehend aus mindestens zwei Laserdiodenzeilen, deren Strahlung in der Emissionsebene (x-y-Ebene) einen Querschnitt aufweist, dessen Längsachse ein Vielfaches der Querachse beträgt, je einer, einer Laserdiodenzeile in Strahlungsrichtung nachgeordneten Kollimatoreinheit (1), einer Kombiniereinheit (2) zum Zusammenführen der kollimierten Strahlung der einzelnen Laserdiodenzeilen durch Nebeneinanderordnung in Richtung der Querachse und einer Rekombiniereinheit (3), zum Trennen der zusammengeführten Strahlung in Richtung der Längsachsen in einzelne Teilstrahlungen und Wiedervereinigung durch Nebeneinanderordnung in Richtung der Querachsen.

2. Anordnung nach Anspruch 1, **dadurch gekennzeichnet,**
**daß** zusätzlich eine Sammeloptik (4) vorhanden ist, welche der Rekombiniereinheit (3) nachgeordnet ist und die Strahlung in ein nachfolgendes optisches Element, z.B eine Lichtleitfaser (5) einkoppelt.

3. Anordnung nach Anspruch 1 oder 2, **dadurch gekennzeichnet,**
**daß** die Kollimatoreinheit (1) aus einer Einzelzylinderlinse (6) besteht, die die Strahlung der Laserdiodenzeile in Richtung der Querachse kollimiert.

4. Anordnung nach Anspruch 3, **dadurch gekennzeichnet,**
**daß** die Kollimatoreinheit (1) zusätzlich eine Zylinderlinsenzeile umfaßt, die die Strahlung der Laserdiodenzeile in Richtung der Längsachse kollimiert.

5. Anordnung nach Anspruch 3 oder 4, **dadurch gekennzeichnet,**
**daß** die Zylinderlinsen ein asphärisches Profil aufweisen, um sphärische Aberrationen zu eliminieren.

6. Anordnung nach Anspruch 3 oder 4, **dadurch gekennzeichnet,**
**daß** die Zylinderlinsen Gradientenindexlinsen sind.

7. Anordnung nach Anspruch 1, **dadurch gekennzeichnet,**
**daß** die Kombiniereinheit (2) als ein integriert-optisches Element konstruiert ist und aus Platten mit transparenten und reflektierenden Facetten besteht.

8. Anordnung nach Anspruch 1, **dadurch gekennzeichnet,**
**daß** die Rekombiniereinheit (3.1) ein integriert-optisches Element ist, welches mindestens vier Rechteckstäbe mindestens zweier verschiedener Längen mit jeweils einer 45°-Facette umfaßt, die in Reihenfolge abnehmender Länge zwei Stapel bilden und jeweils zwei Rechteckstäbe unterschiedlichen Stapels ein Stäbepaar mit der gleichen optischen Weglänge bilden und so zueinander angeordnet sind, daß die in Richtung der Stabachse des ersten der zwei Rechteckstäbe auf dessen 45°-Facette auftreffende Strahlung zur 45°-Facette des zweiten der zwei Rechteckstäbe reflektiert wird und diesen in Richtung seiner Stabachse verläßt und die Anzahl der Stäbepaare die Anzahl der entstehenden Teilstrahlungen bestimmt.

9. Anordnung nach Anspruch 1, **dadurch gekennzeichnet,**
**daß** die Rekombiniereinheit (3) aus mindestens einem Modul (3.2) besteht, der in Strahlungsrichtung ein Rhomboidprismenpaar 7 zur Teilung der Strahlung in zwei Teilstrahlungen, sowie zwei Halbwürfelprismen 8 und ein Prisma 9 umfaßt.

10. Anordnung nach Anspruch 9, **dadurch gekennzeichnet,**
**daß** die Rekombiniereinheit (3) aus M Modulen (3.2), die in Strahlungsrichtung hintereinander angeordnet sind, besteht, und damit eine 2^{M}-fache Strahlungsteilung bewirkt wird.

11. Anordnung nach Anspruch 10, **dadurch gekennzeichnet,**
**daß** den beiden Halbwürfelprismen (8) je eine Linse (10) vorgeordnet ist und jeweils die Brennebenen der Linsen (10) benachbarter Module (3.2) zusammenfallen und somit einen Linsenwellenleiter bilden.

## Claims

1. Arrangement for combining and shaping the radiation of a plurality of laser diode lines, comprising at least two laser diode lines whose radiation has a cross section in the emission plane (x-y plane) whose longitudinal axis is a multiple of the transverse axis, one collimator unit (1) for each laser diode line arranged downstream thereof in the radiation direction, a combining unit (2) for combining the collimated radiation of the individual laser diode lines by means of a side-by-side arrangement in the direction of the transverse axis, and a recombining unit (3) for dividing the combined radiation in the direction of the longitudinal axes into individual partial beams and recombining the latter by means of a side-by-side arrangement in the direction of the transverse axes.

2. Arrangement according to claim 1, **characterized in that** collecting optics (4) are additionally provided and are arranged downstream of the recombining unit (3) and couple the radiation into an optical element, e.g., a light-conducting fibre (5), arranged downstream.

3. Arrangement according to claim 1 or 2, **characterized in that** the collimator unit (1) is formed of an individual cylindrical lens (6) which collimates the radiation of the laser diode line in the direction of the transverse axis.

4. Arrangement according to claim 3, **characterized in that** the collimator unit (1) additionally comprises a cylindrical lens line which collimates the radiation of the laser diode line in the direction of the longitudinal axis.

5. Arrangement according to claim 3 or 4, **characterized in that** the cylindrical lenses have an aspherical profile to eliminate spherical aberrations.

6. Arrangement according to claim 3 or 4, **characterized in that** the cylindrical lenses are gradient index lenses.

7. Arrangement according to claim 1, **characterized in that** the combining unit (2) is constructed as an integrated optical element and comprises plates with transparent and reflecting facets.

8. Arrangement according to claim 1, **characterized in that** the recombining unit (3.1) is an integrated optical element which is formed of at least four rectangular rods of at least two different lengths, each with a 45-degree facet, which rectangular rods form two stacks in order of decreasing length, and every two rectangular rods of different stacks form a pair of rods with the same optical path length and are so arranged relative to one another that the radiation impinging on the 45-degree facet of the first of the two rectangular rods in the direction of its axis is reflected to the 45-degree facet of the second of the two rectangular rods and exits the latter in the direction of its axis, and the quantity of rod pairs determines the quantity of occurring partial beams.

9. Arrangement according to claim 1, **characterized in that** the recombining unit (3) is formed of at least one module (3.2) which includes, in the radiation direction, one rhomboid prism pair 7 for dividing the beams into two partial beams, two half-prisms 8, and a prism 9.

10. Arrangement according to claim 9, **characterized in that** the recombining unit (3) is formed of M modules (3.2) which are arranged one behind the other in the radiation direction and thus form 2^{M} partial beams.

11. Arrangement according to claim 10, **characterized in that** a lens (10) is arranged in front of each half-prism (8) and the focal planes of the lenses (10) of adjacent modules (3.2) coincide and accordingly form a lens waveguide.

## Revendications

1. Dispositif pour réunir et former le rayonnement de plusieurs lignes de diodes laser, constitué d'au moins deux lignes de diodes laser dont le rayonnement présente, dans le plan d'émission (plan x-y), une section transversale dont l'axe longitudinal est un multiple de l'axe transversal, d'une unité de collimation (1) disposée en aval de chaque ligne de diodes laser dans la direction du rayonnement, d'une unité de combinaison (2) pour réunir le rayonnement collimaté de chacune des lignes de diodes laser par juxtaposition dans la direction de l'axe transversal, et d'une unité de recombinaison (3) pour séparer le rayonnement réuni dans la direction des axes longitudinaux, en rayonnements partiels individuels, et nouvelle réunion par juxtaposition dans la direction des axes transversaux.

2. Dispositif selon la revendication 1, **caractérisé en ce qu'**il est prévu en outre une optique de collecte (4) qui est disposée en aval de l'unité de combinaison (3) et qui envoie le rayonnement dans un élément optique suivant, par exemple une fibre optique (5).

3. Dispositif selon la revendication 1 ou 2, **caractérisé en ce que** l'unité de collimation (1) est constituée d'une lentille cylindrique et unique (6) qui collimate le rayonnement de la ligne de diodes laser, dans la direction de l'axe transversal.

4. Dispositif selon la revendication 3, **caractérisé en ce qu'**une unité de collimation (1) comprend en outre une ligne de lentilles cylindriques qui collimate le rayonnement de la ligne de diodes laser dans la direction de l'axe longitudinal.

5. Dispositif selon la revendication 3 ou 4, **caractérisé en ce que** les lentilles cylindriques présentent un profil non sphérique pour éliminer les aberrations sphériques.

6. Dispositif selon la revendication 3 ou 4, **caractérisé en ce que** les lentilles cylindriques sont des lentilles à indice de gradient.

7. Dispositif selon la revendication 1, **caractérisé en ce que** l'unité de combinaison (2) est construite en tant qu'élément optique intégré et est constituée de plaques à facettes transparentes réfléchissantes.

8. Dispositif selon la revendication 1, **caractérisé en ce que** l'unité de recombinaison (3.1) est un élément optique intégré qui comprend au moins quatre barres rectangulaires d'au moins deux longueurs différentes avec chacune une facette à 45°, qui forment dans l'ordre de la longueur décroissante, deux piles, et deux barres rectangulaires de piles différentes forment une paire de barres de même longueur de trajet optique et sont disposées de manière que le rayonnement, parvenant dans la direction de l'axe de la première des deux barres rectangulaires, sur sa facette à 45°, soit réfléchi vers la facette à 45° de la deuxième des deux barres rectangulaires, et sorte de celles-ci dans la direction de son axe de barre, et le nombre de paires de barres détermine le nombre de rayonnements partiels qui se forment.

9. Dispositif selon la revendication 1, **caractérisé en ce que** l'unité de recombinaison (3) est constituée d'au moins un module (3.2) qui comprend, dans la direction du rayonnement, une paire de prismes rhomboïdaux (7) pour la division du rayonnement en deux rayonnements partiels, ainsi que deux prismes en demi-cube (8) et un prisme (9).

10. Dispositif selon la revendication 9, **caractérisé en ce que** l'unité de recombinaison (3) est constituée de M modules (3.2) qui sont disposés l'un derrière l'autre dans la direction du rayonnement, et il est ainsi provoqué une division multiple de 2^{M} du rayonnement.

11. Dispositif selon la revendication 10, **caractérisé en ce qu'**en amont de chacun des deux prismes à demi-cube (8) est disposée une lentille (10) et les plans focaux des lentilles (10) de modules (3.2) voisins coïncident et forment ainsi un guide d'ondes des lentilles.
